# EUROPÄISCHE PATENTSCHRIFT

(11) **EP 0 428 866 B1**
(45) Veröffentlichungstag und Bekanntmachung des Hinweises auf die Patenterteilung: **11.01.1995**
(21) Anmeldenummer: 90119698.0
(22) Anmeldetag: 15.10.1990
(51) Int. Cl.: H04H 1/00

(54) **Verfahren und Anordnung zur Unterdrückung von Senderwechseln in RDS-Empfängern bei lokalen Störungen**
Method and apparatus for suppressing transmitter change-over in RDS receivers due to local disturbances
Procédé et dispositif pour supprimer les changements d'émetteur dans des récepteurs avec RDS dûs à des perturbations locales

(30) Priorität: 17.11.1989 DE 3938269
(43) Veröffentlichungstag der Anmeldung: 29.05.1991
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Kalmer, Mathias, Grundig E.M.V. Max Grundig, W-8510 Fuerth (DE)

(56) Entgegenhaltungen:
- EP-A- 0 201 681
- EP-A- 0 211 366
- EP-A- 0 275 527

## Beschreibung

Die Erfindung betrifft eine Verfahren und eine Anordnung zur Unterdrückung von automatisch durchgeführten Programmwechseln in mobilen Rundfunkempfangsgeräten, welche Signale nach dem Radio-Daten-System (RDS) verarbeiten können, wobei sich das erfindungsgemäße Verfahren insbesondere auf lokale Störungen, die nicht das gesamte Frequenzband betreffen, bezieht.

Bei RDS-Empfangsgeräten werden in der Regel bei Abfall der Empfangsqualität unter eine vorbestimmte Grenze Senderwechsel vollzogen. In der deutschen Offenlegungsschrift DE-OS 38 32 455 wird ein Auswahlverfahren beschrieben, nach dem die Empfangsfrequenz sequentiell auf die Frequenz einer anderen Station der gleichen Programmkette geändert wird. Wenn die Frequenz mit dem höchsten Empfangssignalpegel die gleichen Programmidentifikationsdaten enthält wie der eingestellt Sender, wird auf den neuen Sender umgestellt.

Bei derartigen Empfängern ist es bekannt, daß ein Sendersuchlauf gestartet wird, wenn keine empfangbare alternative Frequenz gefunden wird.

In Gebieten, die durch geographische oder sonstige Gegebenheiten nicht so gut versorgt sind, daß immer alternative Frequenzen zum eingestellten Programm empfangen werden können oder, wenn der eingestellte Sender ein regionaler Sender ist, der sein Programm nur auf einer Frequenz abstrahlt, kann unter ungünstigen Umständen ein unerwünschter Sendersuchlauf vollzogen werden.

Besonders in Stadtgebieten kann leicht der Fall eintreten, daß der für die Region zuständige Sender stellenweise keine ausreichende Qualität aufweist. Während solche Störungen beim fahrenden Auto überbrückt werden, da sie in der Regel nur von sehr kurzer Dauer sind, kann bei stehendem Auto ein unerwünschter Sendersuchlauf ausgelöst werden.

Es ist deshalb Aufgabe der Erfindung eine unerwünschte Auslösung des Sendersuchlaufes bei kurzzeitigen lokalen Störungen zu verhindern.

Bei der Lösung dieser Aufgabe wird von der Annahme ausgegangen, daß der beim Abstellen des Fahrzeugs eingestellte Sender in ausreichender Empfangs-Qualität empfangbar war, wenn die Empfangsqualität durch verschiedene Kriterien und ihre Kombinationen angegeben werden kann, wie z.B. Mehrwegempfangsstörungen, Empfangsfeldstärke, RDS-Fehlerrate usw.. Wenn nun bei späterem Einschlaten des Empfängers diese Qualität nicht mehr gegeben ist, liegt mit großer Wahrscheinlichkeit eine örtliche Abschattung vor, die durch ein Haus, einen LKW oder ein Garagentor usw. verursacht ist und lokal begrenzt ist. Um hier einen unerwünschten Sendersuchlauf bzw. Senderwechsel zu vermeiden wird bei Inbetriebnahme des RDS-Empfangsgerätes zunächst der vor dem Abschalten eingestellte Sender wieder eingestellt und durch Vergleich mit einem ersten Schwellwert überprüft, ob ausreichende Empfangsqualität gegeben ist. Wenn dies nicht der Fall ist, werden zunächst alle abgespeicherten alternativen Frequenzen überprüft. Ist auch hier keine Frequenz in ausreichender Qualität zu empfangen, soll erfindungsgemäß der zuletzt beim Ausschalten eingestellte Sender wieder eingestellt werden und für eine begrenzte Zeit eingestellt bleiben.

Eine vorteilhafte Weiterbildung der Erfindung besteht darin, daß die Empfangsqualität des wiedereingestellten Senders durch Vergleich mit einem zweiten Schwellwert überprüft wird und daß das Empfangsgerät stummgeschaltet wird, wenn auch dann die Qualität zum Hören des Programms nicht ausreicht, d.h. wenn auch der zweite Schwellwert unterschritten wird.

Figur 1 zeigt in Figur 1a den zeitlichen Verlauf der Abstimmspannung Uₐ, in 1b die Ein/Ausschaltspannung Uₛ, in 1c den Verlauf der Empfangsqualität Eₑ und in 1d das Steuersignal Sts für die Stummschaltung.

Figur 2 zeigt eine Anordnung zur Durchführung des erfindungsgemäßen Verfahrens.

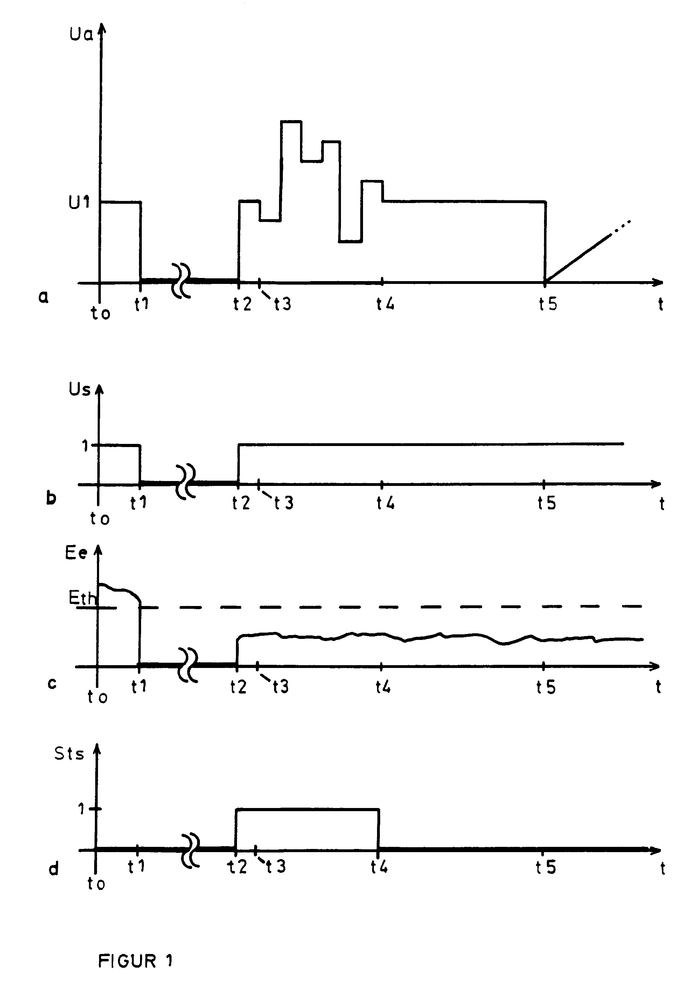

Im folgenden wird die Erfindung an Hand der Figur 1 erläutert.

Im Zeitraum t₀ bis t₁ ist das Autoradio angestellt und auf einen Sender der Frequenz f₁ mit der Abstimmspannung U₁ abgestimmt. Die Empfangsqualität hat zu diesem Zeitpunkt einen Wert, der für die Verarbeitung von RDS-Daten ausreichend ist. Zum Zeitpunkt t₁ wird das Auto abgestellt und somit das Radio ausgeschaltet, d.h. die Ein/Ausschaltspannung nimmt den Ausschaltwert Null an und der Wert der gemessenen Empfangsfeldstärke sinkt ebenfalls auf Null.

Im Zeitpunkt t₂ wird das Radio wieder angeschaltet. Uₛ nimmt den Einschaltwert Eins an und es wird wieder auf die vor dem Abschalten eingestellte Frequenz f₁ mit der Abstimmspannung U₁ abgestimmt. Wenn der Fahrzeugstandort für die Abstimmfrequenz f₁, auf welcher der für die Region zuständige RDS-Sender einer Programmkette bzw. ein örtlicher RDS-Sender sendet durch eine Abschattung gestört ist, erreicht der Wert, der die Empfangsqualität angibt nicht den Grenzwert Eₜₕ. Zum Zeitpunkt t₂ wird deshalb mit dem Steuersignal Sts der Empfänger stummgeschaltet und es werden der eingestellte Sender sowie die alternativen Frequenzen, soweit welche vorhanden sind, auf RDS-Empfangstauglichkeit geprüft. Wenn keine alternative Frequenz in ausreichender Qualität empfangbar ist, wird die vor dem Abschalten eingstellte Frequenz f₁ mit der Abstimmspannung U₁ wieder eingestellt und für eine vorbestimmbare Zeitdauer gehalten, bevor zu einem späteren Zeitpunkt t₅ ein Sendersuchlauf gestartet wird. Nach Überprüfung der alternativen Frequenzen wird zum Zeitpunkt t₄ das Steuersignal Sts für die Stummschaltung wieder rückgesetzt.

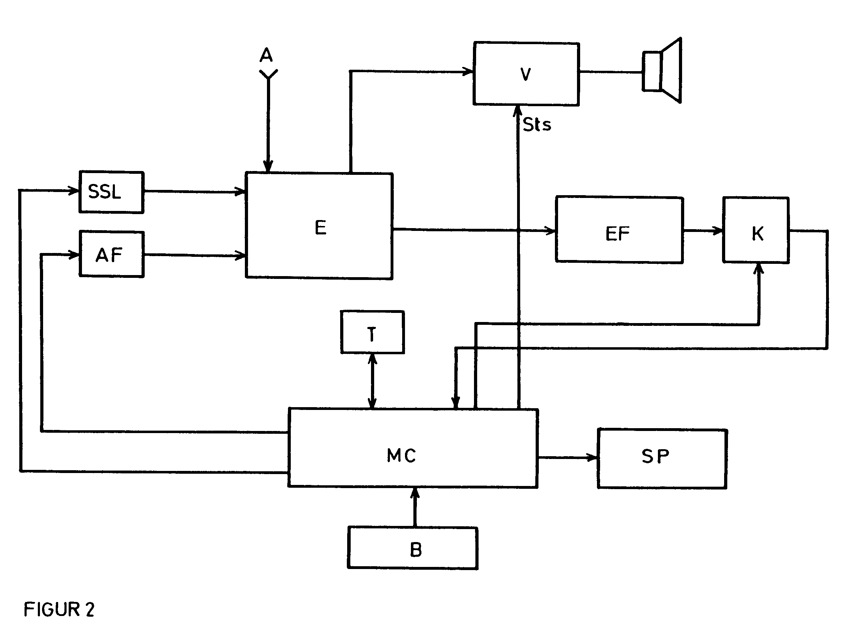

In Figur 2 ist zur weiteren Erläuterung der Erfindung ein Blockschaltbild angegeben, das die erfindungswesentlichen Funktionsblöcke und Verbindungen enthält.

Vom Antennenanschluß A führt eine Verbindungsleitung zum Empfangsteil E. Zum Empfangsteil E führen Leitungen von den Funktionsblöcken SSL, der die Sendersuchlaufsteuerung beinhaltet, und AF, von dem aus die Überprüfung der alternativen Frequenzen gesteuert wird. Vom Empfangsteil E führen Leitungen zur Verstärkereinheit V und zum Funktionsblock EF. Im Block EF wird die Empfangsfeldstärke bzw. andere Kriterien zur Beurteilung der Empfangsqualität, wie z.B. Fehlerrate bei RDS-Daten und ähnliches bewertet. Das Ausgangssignal dieser Einheit EF wird an den Komparator K geleitet. Ein zweites Eingangssignal an den Komparator K wird über eine Verbidnung zum Mikrocomputer MC geleitet. Vom Mikrocomputer MC führen entsprechende Verbindungsleitungen zu den Funktionsblöchen SSL, AF sowie zur Verstärkereinheit V. Über bidirektionale Leitungen sind auch der Speicher SP sowie der Timerblock T mit dem Mikrocomputer MC verbunden. Zum Mikrocomputer MC werden Signale vom Komparator K und der Bedieneinheit B gegeben.

Die dargestellten Funktionsblöcke können sowohl schaltungstechnisch ausgeführt sein als auch durch ein Mikrocomputerprogramm, wobei im letzten Fall die dargestellten Funktionsblöcke Programmblöcke sind.

Beim Einschalten des Gerätes mit Hilfe der Bedieneinheit B wird zunächst auf den zuletzt eingestellten Sender abgestimmt. Dazu werden aus dem speicher SP die Abstimmdaten in den Mikrocomputer MC gelesen, dort verarbeitet und entsprechende Steuersignale an die Suchlaufsteuerung SSL gegeben. Von dieser wird eine den Abstimmdaten gemäße Abstimmspannung an das Empfangsteil E gegeben. Der empfangene Sender wird dann im Funktionsblock EF in der Weise aufbereitet, daß am Ausgang dieses Blocks ein der Empfangsqualität entsprechendes Signal angelegt wird, das zum Komparator K geführt wird, in dem es mit vom Mikrocomputer MC vorgegebenen Grenzwerten verglichen wird. Das Vergleichsergebnis wird an den Mikrocomputer MC geführt und dort verarbeitet. Wenn der nach dem Einschalten eingestellte Sender unter der Qualitätsgrenze liegt, die für die Verarbeitung von RDS-Daten notwendig ist, werden die im Speicher SP abgelegten alternativen Frequenzen überprüft. Dazu werden die Abstimmdaten sequentiell aus dem Speicher SP in den Mikrocomputer MC gelesen. Dieser gibt nach Aufbereitung der Daten die notwendigen Steuersignale an den Funktionsblock AF, der wiederum die Steuersignale in die entsprechenden Abstimmspannungen umwandelt und an das Empfangsteil E weitergibt.

Die Überprüfung auf Empfangsqualität erfolgt analog zur oben beschriebenen Überprüfung des nach dem Einschalten eingestellten Senders. Liegt auch bei den alternativen Frequenzen keinen ausreichende Empfangsqualität vor bzw. gibt es keine alternativen Frequenzen, dann wird in oben beschriebenener Weise der nach dem Einschalten ursprünglich eingestellte Sender wieder eingestellt und bleibt für eine bestimmte Zeit eingestellt, ehe ein Suchlauf gestartet wird. Die Zeitdauer zwischen Überprüfung der alternativen Frequenzen, bzw. Einstellen und Überprüfen des vor dem Abschalten eingestellen Senders und dem Sendersuchlauf, steuert der Timerblock T, wobei Anfangs- und Endzeit des Timerblocks T vom Mikrocomputer MC vorgegeben werden.

In einer vorteilhaften Weiterbildung des Erfindungsgedankens wird die Empfangsqualität dieses eingestellten Senders mit einem zweiten Grenzwert verglichen, der einen Schwellwert für ausreichende Hörqualität angibt und der niedriger ist als der Grenzwert, der RDS-Qualität angibt. Wenn die Empfangsqualität diesen zweiten Grenzwert unterschreitet, wird vom Mikrocomputer MC ein Steuersignal Sts für die Stummschaltung der Verstärkereinheit V ausgegeben.

## Patentansprüche

1. Verfahren zur Unterdrücking von automatisch durchgeführten Programmwechseln in mobilen Rundfunkempfangsgeräten, welche Signal nach dem Radio-Daten-System (RDS) verarbeiten können, bei lokalen Störungen, die nicht das gesamte Frequenzband betreffen, **dadurch gekennzeichnet**, daß dann, wenn beim Anschalten des Rundfunkempfängergerätes das vor dem Abschalten eingestellte Programm nicht in ausreichender Empfangsqualität empfangbar ist, zunächst alle gespeicherten alternativen Frequenzen der gleichen Programmkette durch Vergleich mit einem ersten Schwellwert überprüft werden, und daß dann, wenn auch die alternativen Frequenzen nicht in ausreichender Qualität empfangbar sind oder wenn keine alternativen Frequenzen abgespeichert sind, der vor dem Abschalten des Gerätes eingestellte Sender wieder eingestellt wird und für eine vorgegebene Zeitdauer eingestellt bleibt.

2. Verfahren nach Anspruch 1, **dadurch gekennzeichnet**, daß bei Empfang eines Senders in nicht aureichender Qualität im Vergleich mit dem ersten Schwellwert die Empfangsqualität mit einem zweiten Schwellwert verglichen wird, der eine untere Grenze für Hörqualität angibt und daß beim Unterschreiten dieses Schwellwertes das Empfangsgerät stummgeschaltet wird.

3. Anordnung zur Durchführung des Verfahrens nach den Ansprüchen 1 und 2, gekennzeichnet durch folgende Funktionsblöcke
- ein Empfängerteil (E), welches die von einer Antenne (A) empfangenen Signale verarbeitet und seine Ausgangssignale über einen Verstärker (V) an einen Lautsprecher gibt,
- einen Funktionsblock (EF), der die Feldstärke des im Empfängerteil (E) empfangenen Signals bewertet und ein der Empfangsqualität entsprechendes Signal an einen Komparator (K) leitet, in dem es mit einem von einem Mikrocomputer (MC) vorgegeben Schwellensignal verglichen wird und das Vergleichsergebnis zur Auswertung an den Mikrocomputer (MC) zurückgeführt wird,
- eine Speicher (SP), in dem eine Liste von alternativen Frequenzen, die den gleichen Programminhalt wie der eingestellte Sender haben, abgelegt ist,
- Abstimmblöcke zum Abstimmen der alternativen Frequenzen (AF) und zur Steuerung des Sendersuchlaufes (SSL).
- ein Timer (T), der mit dem Mikrocomputer (MC) verbunden ist, und der die Zeitdauer vorgibt, für die ein vor dem Abschalten des Gerätes eingestellter Sender nach Überprüfen der alternativen Frequenzen und vor einem Sendersuchlauf, wieder eingestellt wird.

## Claims

1. Method of suppressing automatically performed programme changes in mobile radio receivers which are capable of processing signals by the radio data system (RDS), in the case of local interference which does not affect the entire band, characterized in that, if the programme tuned before switching-off is not receivable with adequate reception quality on switching-on the radio receiver, all the stored alternative frequencies of the same programme service are first checked by comparison with a first threshold value, and in that, if the alternative frequencies are also not receivable with adequate quality or if no alternative frequencies are stored, the station tuned before the set was switched off is retuned and remains retuned for a set time duration.

2. Method according to Claim 1, characterized in that if a station is not received with adequate quality compared with the first threshold value, the reception quality is compared with a second threshold value which specifies a lower limit for listening quality, and in that, if this threshold value is not reached, the receiver is muted.

3. Device for implementing the method according to Claims 1 and 2, characterized by the following functional blocks:
- a receiving section (E) which processes signals received from an aerial (A) and passes its output signals via an amplifier (V) to a loudspeaker,
- a functional block (EF) which assesses the field strength of the signal received in the receiving section (E) and feeds a signal corresponding to the reception quality to a comparator (K), in which it is compared with a threshold signal set by a microcomputer (MC), and the comparison result is fed back to the microcomputer (MC) for evaluation,
- a memory (SP) in which a list of alternative frequencies having the same programme content as the tuned station is stored,
- tuning blocks for tuning the alternative frequencies (AF) and for controlling the station search (SSL),
- a timer (T) which is connected to the microcomputer (MC) and sets the time duration for which a station tuned before the set was switched off is retuned after checking the alternative frequencies and prior to a station search.

## Revendications

1. Procédé pour supprimer des changements de programmes, exécutés de façon automatique, dans des appareils de réception radio mobiles, qui peuvent traiter des signaux selon le système de transmission de données radio (RDS), dans le cas de perturbations locales, qui ne concernent pas l'ensemble de la bande des fréquences, caractérisé en ce que, lorsque, lors de l'allumage de l'appareil récepteur radio, le programme réglé avant l'arrêt ne peut pas être reçu avec une qualité de réception suffisante, tout d'abord toutes les autres fréquences mémorisées de la même chaîne de programme sont contrôlées par comparaison à la première valeur de seuil, et lorsque également les autres fréquences ne peuvent pas être reçues avec une quantité suffisante ou lorsqu'aucune autre fréquence n'est mémorisée, l'émetteur réglé avant l'arrêt de l'appareil est à nouveau réglé et reste réglé pendant un intervalle de temps prédéterminé.

2. Procédé selon la revendication 1, caractérisé en ce que lors de la réception d'un émetteur avec une qualité insuffisante par comparaison à la première valeur de seuil, la qualité de réception est comparée à une seconde valeur de seuil, qui indique une limite inférieure pour la qualité d'audition et que, lors du dépassement de cette valeur de seuil par valeurs inférieures, l'appareil de réception est rendu muet.

3. Dispositif pour la mise en oeuvre du procédé selon les revendications 1 et 2, caractérisé par les blocs fonctionnels suivants :
- une partie formant récepteur (E), qui traite les signaux reçus d'une antenne (A) et envoie ces signaux de sortie par l'intermédiaire d'un amplificateur (V) à un haut-parleur,
- un bloc fonctionnel (EF), qui évalue l'intensité de champ du signal reçu dans la partie formant récepteur (E) et envoie un signal qui correspond à la qualité de réception à un comparateur (K), dans lequel il est comparé à un signal de seuil prédéterminé par un micro-ordinateur (MC), et le résultat de la comparaison est renvoyé à des fins d'évaluation au micro-ordinateur (MC),
- une mémoire (SP), dans laquelle est mémorisée une liste d'autres fréquences, qui possèdent le même contenu en programmes que l'émetteur réglé,
- des blocs de réglage d'accord, servant à réaliser le réglage d'accord des autres fréquences (AF) et à commander le cycle de recherche d'émetteur (SSL),
- une horloge (T) qui est reliée au micro-ordinateur (MC) et indique la durée pour laquelle un émetteur réglé avant l'arrêt de l'appareil est à nouveau réglé, après contrôle des autres fréquences et avant un cycle de recherche d'émetteur.
